Europäisches Patentamt

European Patent Office

Office européen des brevets

(19)

(11) Numéro de publication : **0 305 260 B1**

# (12) FASCICULE DE BREVET EUROPEEN

(45) Date de publication du fascicule du brevet :
**22.07.92 Bulletin 92/30**

(51) Int. Cl.$^5$ : **H01L 21/68,** H01L 21/00,
    B65G 51/03

(21) Numéro de dépôt : **88402061.1**

(22) Date de dépôt : **08.08.88**

(54) **Transporteur de tranches empilables dans des cassettes.**

(30) Priorité : **11.08.87 FR 8711419**

(43) Date de publication de la demande :
**01.03.89 Bulletin 89/09**

(45) Mention de la délivrance du brevet :
**22.07.92 Bulletin 92/30**

(84) Etats contractants désignés :
**BE DE GB IT NL**

(56) Documents cités :
**DE-A- 2 626 528
FR-A- 2 483 377
US-A- 3 717 381
US-A- 4 299 518**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **Cruz, Didier
109, Avenue Jean Jaurès
F-38000 Grenoble (FR)**
Inventeur : **Daval, Jacques
8, rue Champ de la Cour
F-38240 Meylan (FR)**
Inventeur : **Lazzari, Jean-Pierre
45, Chemin de Malanot
F-38400 Corenc (FR)**

(74) Mandataire : **Mongrédien, André et al
c/o BREVATOME 25, rue de Ponthieu
F-75008 Paris (FR)**

EP 0 305 260 B1

**Description**

La présente invention a pour objet un transporteur de tranches empilables dans des cassettes et peut s'appliquer en particulier au transport de tranches quasi-circulaires de silicium dans des atmosphères propres pour l'élaboration de circuits intégrés.

Un problème majeur qui se pose dans cette industrie concerne en effet la propreté : il faut absolument éviter la génération de poussières notamment lors du transport des cassettes munies des tranches et des transferts des tranches effectués d'une cassette à une autre. Pour ces dernières opérations, on a envisagé divers systèmes dont un des plus intéressants consiste à employer une piste à coussin d'air. Un dispositif de transport de tranches empilées dans une cassette au moyen d'une piste à coussin d'air est décrit dans US-A-4 299 518. Les cassettes se présentent en effet, comme le montre la figure 1, sous la forme de deux peignes verticaux 21 et 22 disposés parallèlement et réunis par une structure de liaison 23. Les peignes 21 et 22 présentent des dents horizontales 24 séparées par des intervalles latéraux 25. Les dents 24 des deux peignes 21 et 22 sont au même niveau, si bien qu'il est possible de glisser des parties périphériques opposées de tranches de silicium quasi-circulaires 1 dans deux intervalles 25 de même niveau appartenant chacun à un peigne 21 et 22 et, en poussant la tranche 1 vers la structure de liaison 23, de faire reposer également sa circonférence arrière dans un intervalle arrrière 25′, joignant les deux intervalles latéraux 25 de même niveau. Le centre de la tranche 1, de même que sa partie périphérique avant, reste dégagé.

Dans le système de l'art antérieur, ces cassettes 20 reçoivent ainsi plusieurs dizaines de tranches 1 superposées et sont utilisées pour leur transport. Pour le transfert d'une cassette 20 à une autre, on utilise donc une piste à coussin d'air. La cassette 20 subit une translation verticale de façon à ce que la piste soit à peu près au niveau d'une paire de dents 24 sur lesquelles repose la tranche 1 à extraire, puis la cassette 20 est avancée de façon à ce que la piste pénètre entre les deux peignes 21 et 22. Un petit mouvement de translation verticale de la cassette 20 amène la piste presque en contact avec la tranche 1, après quoi on établit le coussin d'air, qui est obtenu grâce à des orifices débouchant sur la face supérieure de la piste avec une obliclté longitudinale, ce qui fait que la tranche 1 est à la fois soulevée des dents 24 et extraite de la cassette 20. Elle circule alors jusqu'à l'autre extrémité de la piste à coussin d'air, qui est insérée dans une deuxième cassette semblable à la première. La tranche 1 est glissée entre deux interstices 25 de cette deuxième cassette jusqu'à ce qu'elle entre en butée contre la structure de liaison 23. Le coussin d'air est alors interrompu et la seconde cassette peut être extraite.

Ce système présente l'avantage de supprimer tous les frottements générateurs de poussières au cours de l'opération de transfert ; malheureusement, ces poussières peuvent aussi être engendrées par vibration lors des opérations de transport des cassettes, et ces opérations sont nombreuses : il faut tout d'abord amener les cassettes près de l'extrémité de la piste à coussin d'air, faire un réglage de position verticale, introduire l'extrémité de la piste entre les peignes, et extraire de nouveau les cassettes pour les refaire pénétrer après une translation verticale si l'on veut répéter l'opération sur plusieurs tranches 1. On peut donc conclure que le système est compliqué et n'est pas entièrement satisfaisant.

L'invention permet de résoudre ces problèmes. Elle concerne en effet, dans sa forme la plus simple, une multiplicité de pistes à coussin d'air présentant le même pas vertical que les dents des peignes 21 et 22, si bien que toutes les tranches 1 sont alors juste au-dessus d'une piste à coussin d'air et qu'il est possible d'extraire en bloc ou séparément les différentes tranches 1 sans qu'aucun réglage vertical de la cassette 20 soit désormais nécessaire.

Selon l'invention, le coussin d'air établi sur chaque piste peut provoquer un mouvement des tranches 1 dans les deux sens longitudinaux, ce qui, en association avec une butée, permet de maintenir les tranches 1 sur les pistes sans devoir prévoir une seconde cassette à leur extrémité. Cette seconde cassette peut être amenée par la suite au même endroit que la précédente après que celle-ci a été extraite. La station de transfert ne prévoit donc plus la coopération que de deux ensembles à la fois au lieu de trois, ce qui la simplifie beaucoup.

Selon une variante de réalisation, les pistes sont munies près de la butée d'un orifice de succion permettant d'annuler l'effet du coussin d'air et de plaquer les tranches 1 sur leurs pistes respectives. Il s'agit d'un simple atterrissage qui n'implique ni glissement ni frottement et qui produit donc peu de poussières. Les tranches 1 sont alors fermement maintenues sur les pistes, ce qui permet de déplacer éventuellement l'ensemble du dispositif sans risque de vibrations importantes et de faire de ce qui n'était jusqu'ici qu'un simple dispositif de transfert d'une cassette à une autre un véritable dispositif de transport. Enfin, on comprend immédiatement que la multiplicité des pistes rend inutile, en cas de transferts successifs de tranches 1, d'extraire à chaque fois la cassette 20 pour la ramener ensuite contre le transporteur après un mouvement vertical de sélection de tranche 1.

De façon plus précise, l'invention concerne un transporteur de tranches empilées dans une cassette, cette cassette présentant deux peignes verticaux parallèles munis de dents au même niveau, les tranches pouvant reposer sur une paire de peignes à dents de même niveau, ainsi qu'une structure de liaison des peignes, caractérisé en ce qu'il comprend un empilement de plusieurs pistes horizontales de même répartition verticale que les intervalles entre les paires de dents et moins larges que l'écart entre les peignes, chaque piste étant associée à un intervalle et comprenant des conduites de jet d'air débouchant obliquement dans les deux sens longitudinaux sur sa face supérieure, permettant ainsi de déplacer longitudinalement les tranches sur une piste respective par rapport à la cassette sans contact avec cette piste.

Dans une réalisation préférée, le transporteur comprend, à une extrémité, une butée longitudinale pour les tranches, ainsi qu'une conduite de succion plaquant les tranches contre la piste à cet endroit.

L'invention peut être très facilement fabriquée si les pistes sont formées de trois couches jointives, une couche inférieure pleine, une couche médiane rainurée longitudinalement et une couche supérieure percée de trous débouchant dans les rainures.

On va maintenant décrire concrètement l'invention à l'aide des figures annexées dont l'énumération suit, et qui sont données à titre illustratif et non limitatif :

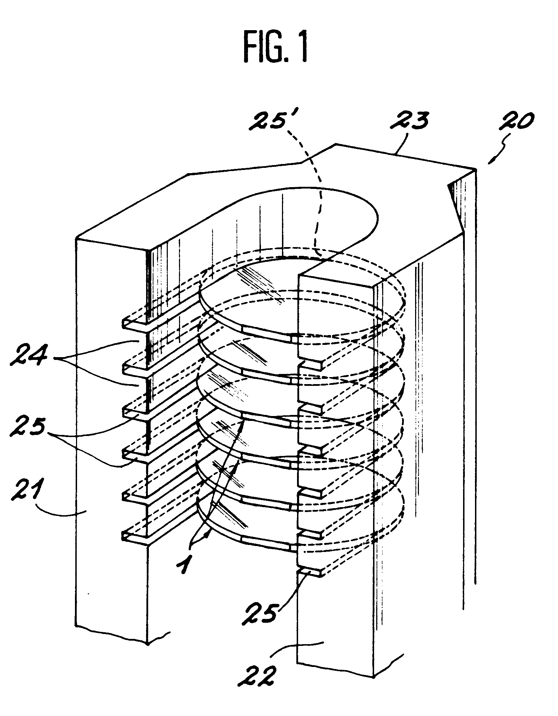

– la figure 1, déjà décrite, représente une cassette où peuvent être empilées des tranches de silicium ;
– la figure 2 représente une vue en perspective de l'invention ;
– les figures 3 et 4 illustrent par une coupe de dessus le fonctionnement de l'invention ;
– la figure 5 illustre un perfectionnement que l'on peut apporter à l'invention ;
– les figures 6 et 7 représentent deux variantes de mise en oeuvre de ce perfectionnement ;
– la figure 8 représente un mode de construction possible des pistes à coussin d'air ; et
– la figure 9 représente un schéma de commande possible.

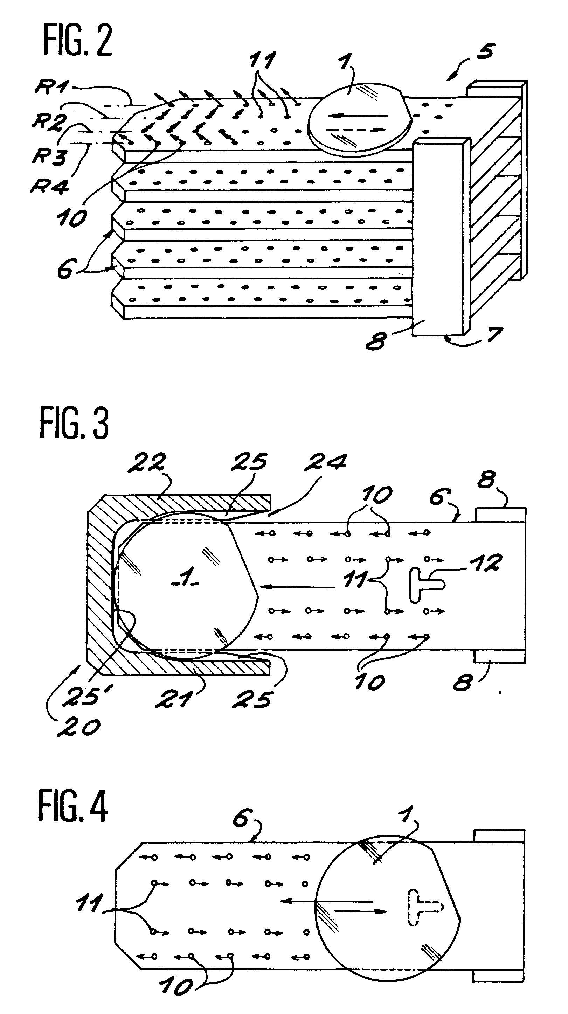

Comme le montre la figure 2, le transporteur selon l'invention, référencé globalement par 5, comprend une multiplicité de pistes horizontales 6, de même pas vertical que les dents 24 des peignes 21 et 22, et de largeur inférieure à l'écart entre ces peignes. Les pistes sont réunies entre elles par un cadre d'assemblage 7 à une extrémité des pistes 6 ; dans cette réalisation, les tranches 1, qui ont un diamètre plus important que la largeur des pistes 6, sont ainsi amenées à entrer en butée contre les montants latéraux 8 du cadre d'assemblage 7. Elles ne peuvent donc pas parcourir la totalité de la longueur des pistes 6. Les pistes sont munies sur leur face supérieure d'une série d'orifices disposés en quatre rangées longitudinales R1, R2, R3 et R4. Ces orifices correspondent à des débouchés de conduits d'air en surpression et servent à établir un coussin d'air. Les orifices 10 des rangées extrêmes R1 et R4 sont obliques dans un sens longitudinal et projettent ainsi de l'air en direction de la gauche sur le dessin (dans le sens opposé au cadre d'assemblage 7) ; les orifices 11 des deux rangées moyennes R2 et R3 sont également obliques longitudinalement, mais dans l'autre sens (vers la droite sur le dessin), et soufflent donc de l'air à la fois vers le haut et vers le cadre d'assemblage 7. Avantageusement, les deux rangées extrêmes R1 et R4 d'une part, les deux rangées moyennes R2 et R3 d'autre part, sont symétriques par rapport à un même axe médian longitudinal. Comme on va le voir plus loin, le soufflage d'air dans ces divers orifices n'est pas simultané, et on comprendra immédiatement que si l'on souffle de l'air uniquement par les orifices 11 des rangées moyennes R2 et R3, la tranche 1 se trouvant, comme le représente la figure 3, enfoncée dans les intervalles 25 et 25′ de la cassette 20 et juste au-dessus d'une piste 6 sera soulevée des dents 24 et déplacée vers la droite. Le mouvement de translation pourra se poursuivre jusqu'à ce que la tranche 1 entre éventuellement en contact avec les montants latéraux 8 du cadre d'assemblage 7 qui peuvent donc servir de butée horizontale. Dans la représentation de la figure 4, ce mouvement de translation est presque achevé. La cassette 20 peut alors avoir été enlevée.

Les pistes 6 comprennent également une conduite de succion débouchant en un orifice 12 disposé à proximité des montants latéraux 8 et ici en forme de T. D'autres formes sont cependant possibles. Cet orifice de succion 12 est relié à une dépression d'air qui permet, quand la tranche 1 passe au-dessus, de la plaquer contre la piste 6 et de la maintenir solidement en place. C'est ce que représente la figure 4. On peut couper alors l'admission d'air dans les orifices 11 et transporter si nécessaire l'ensemble du transporteur 5 et des tranches 1 sans risque d'engendrer des vibrations vers une autre cassette 20. Le transporteur 5 y pénètre, ses pistes 6 étant au même niveau que les dents 24, et on coupe alors la succion d'air tout en faisant pénétrer de l'air par les orifices 10 des rangées R1 et R4. La tranche 1 est soulevée par établissement d'un nouveau coussin d'air et circule vers la gauche de la piste 6 jusqu'à pénétrer entre les dents 24 et dans les intervalles 25 et 25′. On peut alors couper l'admission d'air et retirer le transporteur 5 : le transfert est achevé, et on retrouve la configuration de la figure 3.

On commence à entrevoir les possibilités importantes de ce dispositif, sa souplesse et sa simplicité d'utilisation : aucun mouvement vertical entre la cassette 20 et le transporteur 5 n'est nécessaire, car une piste 6 est associée à chaque tranche 1. Il en résulte que les cassettes 20 peuvent être vidées ou remplies en une seule opération. Pour le cas où l'on ne s'intéresse qu'à une tranche 1 particulière, il est cependant possible de l'extraire séparément car les pistes 6 sont commandées pneumatiquement de manière indépendante.

Le seul mouvement vertical qui subsiste est un petit mouvement ascendant des pistes 6 quand celles-ci, après avoir pénétré entre les peignes 21 et 22, vont établir le coussin d'air. Il est alors important que le jeu entre les pistes 6 et la tranche 1 reposant sur les dents 24 soit aussi faible que possible. Réciproquement, le transporteur 5 effectue un petit mouvement descendant après avoir rempli une nouvelle cassette 20 et avant d'en ressortir. On peut ainsi disposer de tolérances de fonctionnement plus importantes en évitant tout frottement des pistes 6 contre les tranches 1 lors du mouvement d'extraction ou de pénétration de celles-là. Ce fonctionnement implique que les dents 24 soient un peu plus épaisses que les pistes 6.

Selon un autre avantage, le transporteur 5 n'est plus en relation qu'avec une seule cassette 20 à la fois. La station de transfert est donc très simplifiée. Enfin, le dispositif de succion permet de transporter les tranches 1 sur le transporteur 5, ce qui peut éventuellement permettre de supprimer certaines cassettes de transfert intermédiaires lors des manipulations.

Enfin, il n'est pas nécessaire d'extraire et de rentrer les cassettes par un mouvement de va-et-vient horizontal pour transférer une cassette après l'autre.

D'autres avantages de l'invention, correspondant cette fois-ci à des modes de réalisation plus particuliers, vont maintenant être décrits.

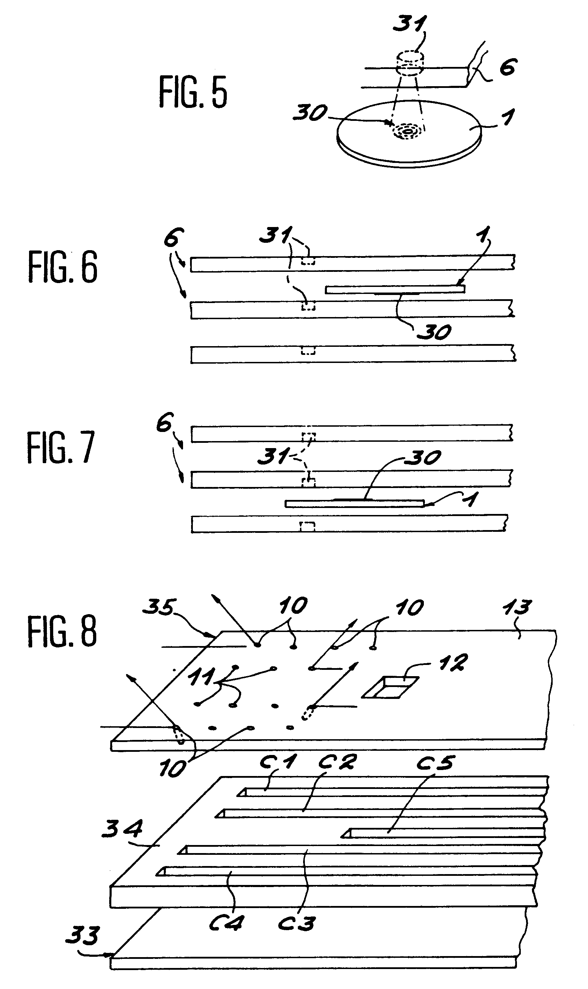

Tout d'abord, comme le représente la figure 5, les pistes 6 peuvent être mises à profit pour porter un dispositif de lecture d'un codage fixé sur les tranches.

Les tranches 1 peuvent être ainsi munies d'un code circulaire 30 formé de cercles concentriques remplissant le rôle des codes en barres pour des objets de révolution qu'on ne peut orienter. Au cours de son glissement sur le coussin d'air, la tranche 1 passe devant une tête de lecture 31 établie sur une piste 6 qui lit le code circulaire 30. Comme les tranches 1 sont centrées à peu près parfaitement dans le sens transversal par les intervalles 25, et que les mouvements sur coussin d'air n'ont en principe qu'une composante longitudinale, aucun décalage transversal du code circulaire 30 et de la tête de lecture n'est à craindre.

On peut distinguer deux variantes principales. Sur la figure 6, les têtes de lecture sont situées sur la face supérieure des pistes 6 et les codes circulaires 30 sont imprimés sur la face inférieure des tranches 1. Sur la figure 7, on a représenté la disposition inverse : les têtes de lecture 31 sont sur la surface inférieure des pistes 6 et les codes circulaires 30 sont imprimés sur la surface supérieure des tranches 1. Il en résulte que les têtes de lecture 31 contrôlent les tranches 1 qui circulent sur la piste 6 immédiatement inférieure. Les deux dispositions sont fonctionnellement équivalentes, mais la seconde présente évidemment le léger désavantage qu'il faut prévoir une piste 6 supérieure supplémentaire ou bien simplement un support uniquement pour pouvoir contrôler la tranche 1 supérieure.

Un mode pratique de réalisation des pistes 6 est celui représenté figure 8. On voit que chaque piste 6 est constituée de trois couches jointives superposées : une couche inférieure 33, une couche médiane 34 et une couche supérieure 35. La couche inférieure 33 est pleine, la couche médiane 34 est entaillée de rainures longitudinales de circulation d'air correspondant, pour quatre d'entre elles, C1, C2, C3 et C4, aux emplacements des rangées R1 à R4 respectivement et, pour la cinquième d'entre elles C5, à l'emplacement de l'axe longitudinal médian de la piste 6 qui débouche dans l'orifice de succion 12.

La couche supérieure 35 est donc percée de part en part par l'orifice de succion 12 et par les orifices 10 et 11 qui servent à engendrer le coussin d'air. Selon une réalisation possible, les deux couches extrêmes 33 et 35 sont en métal et la couche médiane 34 est en matière plastique et usinée par tout moyen adapté ; il en résulte une structure sandwich légère et suffisamment résistante. Selon une autre conception, les deux couches inférieures 33 et 34 sont d'un seul tenant et les différentes rainures C1 à C5 ne sont alors pas traversantes. Dans tous les cas, les jonctions entre les différentes couches 33 à 35 peuvent être effectuées en particulier par collage.

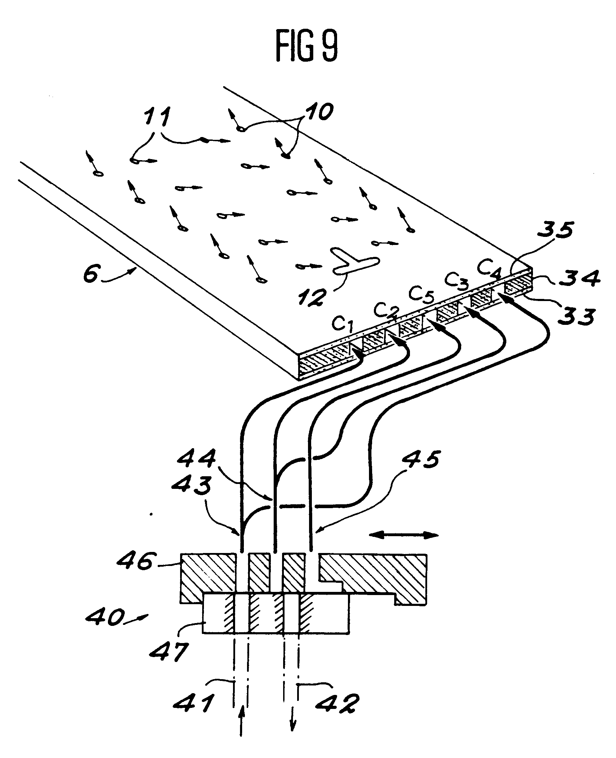

Les rainures C1 à C5 débouchent de la couche médiane 34 du côté du cadre d'assemblage et se raccordent à des conduits d'air. Le schéma de commande pneumatique est représenté figure 9. La pièce maîtresse en est un distributeur, ici à tiroir 40, comprenant en entrée un conduit de pression d'air 41 utilisé pour établir le coussin d'air et un conduit de dépression d'air 42 utilisé pour opérer la succion, et en sortie une première conduite 43 bifurquant ensuite vers les première et quatrième rainures C1 et C4, une deuxième conduite 44 bifurquant ensuite vers les deuxième et troisième rainures C2 et C3 et une troisième conduite 45 aboutissant dans la rainure C5. Le distributeur 40 doit pouvoir prendre trois états, correspondant à l'extraction des tranches 1 des cassettes 20, à leur application contre les pistes 6 par succion, et à l'émission des tranches 1 vers les cassettes 20.

Par conséquent, un des états du distributeur 40 est caractérisé par le fait que la conduite de pression 41 d'air communique avec la première conduite de sortie 43, insufflant ainsi de l'air dans les rainures C1 et C4 et dans les orifices 10, ce qui correspond à l'étape d'émission des tranches 1 vers les cassettes 20. Aucun air ne passe par les orifices 11 et l'orifice de succion 12.

Dans un autre état, quand le tiroir 46 est repoussé, ici vers la gauche, par rapport à la partie fixe 47 du distributeur 40, on fait communiquer à la fois les conduites de pression et de dépression 41 et 42 respectivement avec les deuxième et troisième conduites de sortie 44 et 45 : de l'air est insufflé en direction des orifices 11 et à partir de l'orifice de succion 12. Il en résulte qu'une tranche 1 se trouvant éventuellement dans une cassette 20 en est alors extraite et circule sur le coussin d'air jusqu'au moment où elle arrive au-dessus de l'orifice de succion 12. Elle est alors aspirée et plaquée contre la piste 6.

Il est alors possible de repousser le tiroir 46 vers la droite, dans une position intermédiaire entre les deux précédentes correspondant à un état pour lequel la conduite de pression d'air 41 n'est plus en communication avec aucune des conduites de sortie, mais la conduite de dépression d'air 42 est toujours en communication avec la troisième conduite de sortie 45. Le coussin d'air est alors complètement interrompu et la tranche 1 reste plaquée contre l'orifice de succion 12 et contre la piste 6. Cette position correspond au déplacement du transporteur 5.

Il va sans dire que des dispositifs semblables alimentent les différentes pistes 6. On peut ainsi commander séparément ou simultanément les évolutions de différentes tranches 1.

On voit que la présente invention permet de simplifier énormément les opérations de transport et de transfert de tranches de silicium utilisées dans l'industrie des circuits intégrés. Toutefois, cette application n'est pas la seule envisageable et d'autres peuvent être également envisagées, à la condition que le produit concerné se prête à l'utilisation de manutention par coussin d'air, c'est-à-dire qu'il ait une surface de sustentation suffisamment importante par rapport à son poids.

## Revendications

1. Transporteur (5) de tranches (1) empilées dans une cassette (20), cette cassette présentant deux peignes verticaux parallèles (21, 22) munis de dents (24) au même niveau, les tranches (1) pouvant reposer sur une paire de dents (24) de même niveau, ainsi qu'une structure de liaison (23) des peignes (21, 22), caractérisé en ce qu'il comprend un empilement de plusieurs pistes horizontales (6) de même répartition verticale que les intervalles (25) entre les paires de dents (24) et moins larges que l'écart entre les peignes (21, 22), chaque piste (6) étant associée à un intervalle (25) et comprenant des conduites (C1 à C4) de jet d'air débouchant obliquement dans les deux sens longitudinaux sur sa face supérieure, permettant ainsi de déplacer longitudinalement les tranches (1) sur une piste respective (6) par rapport à la cassette (20) sans contact avec cette piste (6).

2. Transporteur de tranches empilées dans une cassette selon la revendication 1, caractérisé en ce qu'il comprend une butée (8) longitudinale pour les tranches 1 à une extrémité.

3. Transporteur de tranches empilées dans une cassette selon l'une quelconque des revendications 1 ou 2, caractérisé en ce que les pistes (6) comprennent une conduite (C5) de succion d'air débouchant (12) sur leur surface, plaquant là les tranches contre les pistes (6).

4. Transporteur de tranches empilées dans une cassette selon l'une quelconque des revendications 1 à 3, caractérisé en ce que les pistes (6) sont formées de trois couches jointives, une couche inférieure pleine (33), une couche médiane (34) rainurée longitudinalement et une couche supérieure (35) percée de trous (10, 11) débouchant dans les rainures (C1 à C5) correspondant aux conduites.

5. Transporteur de tranches empilées dans une cassette selon l'une quelconque des revendications 1 à 4, caractérisé en ce que les conduites débouchent sur la face supérieure des pistes (6) en rangées longitudinales (R1 à R4).

6. Transporteur de tranches empilées dans une cassette selon la revendication 5, caractérisé en ce qu'il comprend deux couples de rangées longitudinales, l'une comprenant des orifices de débouché (10) de conduites (C1, C4) dans un sens longidutinal, l'autre des orifices de débouché (11) dans l'autre sens (C1, C3), les rangées de chaque couple étant en outre symétriques par rapport à un même axe longitudinal.

7. Transporteur de tranches empilées dans une cassette selon la revendications 3, caractérisé en ce qu'il comprend pour chaque piste (6) un dispositif de distribution pneumatique (40) entre une conduite de pression (41) et une conduite de dépression (42) d'air à l'entrée, et trois conduites (43, 44, 45) à la sortie, pouvant prendre tour à tour un état dans lequel de l'air passe de la conduite de pression dans les conduites débouchant obliquement dans un sens, de l'air passe de la conduite de succion à la conduite de dépression, et de l'air passe de la conduite de pression dans les conduites débouchant obliquement dans l'autre sens.

8. Transporteur de tranches empilées dans une cassette selon l'une quelconque des revendications précédentes, caractérisé en ce que les pistes (6) comprennent sur leur face inférieure un dispositif de lecture (31) d'un code (30) apposé sur la face supérieure de la tranche (1) circulant sur la piste adjacente au-dessous.

9. Transporteur de tranches empilées dans une cassette selon l'une quelconque des revendications 1 à 7, caractérisé en ce que les pistes (6) comprennent sur leur face supérieure un dispositif de lecture (31) d'un code (30) apposé sur la face inférieure de la tranche circulant sur la même piste.

## Patentansprüche

1. Transportvorrichtung (5) für in einer Kassette (20) gestapelte Scheiben (1), wobei diese Kassette zwei parallele, vertikale Kämme (21, 22), die mit Zähnen (24) auf derselben Höhe versehen sind, wobei die Scheiben (1) auf einem Zahnpaar (24) der gleichen Höhe aufliegen kann, ebenso wie eine Verbindungsstruktur (23) für die Kämme (21, 22) aufweist, dadurch gekennzeichnet, daß sie eine Stapelung von mehreren horizontalen Spuren (6) derselben vertikalen Unterteilung wie die Intervalle (25) zwischen den Zahnpaaren (24) und weniger breit als der bestand zwischen den Kämmen (21, 22) umfaßt, wobei jede Spur (6) mit einem Intervall (25) verbunden ist und Leitungen (C1 bis C4) für einen Luftstrahl umfaßt, der schräg in die beiden longitudinalen Richtungen auf ihre obere Fläche mündet, wodurch ermöglicht wird, die Scheiben (1) longitudinal auf einer jeweiligen Spur (6) bezüglich der Kassette (20) ohne Kontakt mit dieser Spur (6) zu bewegen.

2. Transportvorrichtung für in einer Kassette gestapelte Scheiben nach Anspruch 1, dadurch gekennzeichnet, daß sie einen longitudinalen Anschlag (8) für die Scheiben (1) an einem Ende umfaßt.

3. Transportvorrichtung für in einer Kassette gestapelte Scheiben nach einem der Ansprüche 1 oder 2, dadurch gekennzeichnet, daß die Spuren (6) eine Luftsaugleitung (C5) umfassen, die an ihrer Oberfläche endet und dort die Scheiben gegen die Spuren (6) drückt.

4. Transportvorrichtung für in einer Kassette gestapelte Scheiben nach einem der Ansprüche 1 bis 3, dadurch gekennzeichnet, daß die Spuren (6) aus drei verbundenen Schichten bestehen, einer vollen, unteren Schicht (33), einer mittleren, longitudinal gerillten Schicht (34) und einer oberen, von Löchern (10, 11) durchsetzten Schicht (35), die in den den Leitungen entsprechenden Rillen (C1 bis C5) enden.

5. Transportvorrichtung für in einer Kassette gestapelte Scheiben nach einem der Ansprüche 1 bis 4, dadurch gekennieichnet, daß die Leitungen auf der oberen Seite der Spuren (6) in longitudinalen Reihen (R1 bis R4) münden.

6. Transportvorrichtung für in einer Kassette gestapelte Scheiben nach Anspruch 5, dadurch gekennzeichnet, daß sie zwei Paare longitudinaler Reihen umfaßt, wobei das eine Einmündungsbffnungen (10) von Leitungen (C1, C4) in einer longitudinalen Richtung und das andere Einmündungsbffnungen (11) in der anderen Richtung (C2, C3) umfaßt, wobei die Reihen jedes Paare außerdem symmetrisch bezüglich einer gleichen longitudinalen Achse sind.

7. Transportvorrichtung für in einer Kassette gestapelte Scheiben nach Anspruch 3, dadurch gekennzeichnet, daß sie für jede Spur (6) eine Vorrichtung zur pneumatischen Verteilung (40) zwischen einer Druckleitung (41) und einer Unterdruckleitung (42) für Luft am Eingang und drei Leitungen (43, 44, 45) am Ausgang umfaßt, die der Reihe nach einen Zustand einnehmen kann, in dem Luft von der Druckleitung in die schräg in einer Richtung mündenden Leitungen strömt, Luft von der Saugleitung in die Unterdruckleitung strömt und Luft von der Druckleitung in die schräg in die andere Richtung mündenden Leitungen fließt.

8. Transportvorrichtung für in einer Kassette gestapelte Scheiben nach einem der vorhergehenden Ansprüche, dadurch gekennzeichnet, daß die Spuren (6) auf ihrer Unterseite eine Vorrichtung (31) zum Lesen eines Codes (30) umfassen, der auf die Oberseite auf der benachbarten, darunterliegenden Spur sich bewegenden Scheibe gestempelt ist.

9. Transportvorrichtung für in einer Kassette gestapelte Scheiben nach einem der Ansprüche 1 bis 7, dadurch gekennzeichnet, daß die Spuren (6) auf ihrer Oberseite eine Vorrichtung (31) zum Lesen eines Codes (30) umfassen, der auf die Unterseite der auf derselben Spur sich bewegenden Scheibe gestempelt ist.


**Claims**

1. Transporter (5) of wafers (1) stacked in a cassette (20), this cassette having two parallel vertical combs (21, 22) provided with tines (24) at the same level, the wafers (1) being able to rest on a pair of tines (24) of the same level, and a structure (23) for linking the combs (21, 22), characterised in that it comprises a stack of several horizontal tracks (6) of the same vertical spread as the gaps (25) between the pairs of tines (24) and which are not as wide as the separation between the combs (21, 22), each track (6) being associated with one gap (25) and comprising air-jet conduits (C1 to C4) emerging obliquely in the two longitudinal directions on its upper face, thus enabling the wafers (1) to be displaced longitudinally on one respective track (6) in relation to the cassette (20) without contact with this track (6).

2. Transporter of wafers stacked in a cassette according to claim 1, characterised in that it comprises a longitudinal stop (8) for the wafers (1) at one end.

3. Transporter of wafers stacked in a cassette according to either one of claims 1 or 2, characterised in that the tracks (6) comprise an air-suction conduit (C5) emerging (at 12) on their surface, holding down the wafers there against the tracks (6).

4. Transporter of wafers stacked in a cassette according to any one of claims 1 to 3, characterised in that the tracks (6) are formed from three adjacent layers, a solid lower layer (33), a longitudinally grooved intermediate layer (34) and an upper layer (35) pierced with holes (10, 11) emerging in the grooves (C1 to C5) corresponding to the conduits.

5. Transporter of wafers stacked in a cassette according to any one of claims 1 to 4, characterised in that the conduits emerge on the upper face of the tracks (6) in longitudinal rows (R1 to R4).

6. Transporter of wafers stacked in a cassette according to claim 5, characterised in that it comprises two pairs of longitudinal rows, one comprising outlet orifices (10) of conduits (C1, C4) in one longitudinal direction, the other outlet orifices (11) in the other direction (C1, C3), the rows of each pair being furthermore symmetrical in relation to the same longitudinal axis.

7. Transporter of wafers stacked in a cassette according to claim 3, characterised in that it comprises, for each track (6), a pneumatic distribution device (40) between a pressurised-air conduit (41) and a reduced-pressure air conduit (42) at the input and three conduits (43, 44, 45) at the output, being able to assume a state in which, in turn, air passes from the pressure conduit into the conduits emerging obliquely in one direction, air passes from the suction conduit to the reduced-pressure conduit and air passes from the pressure conduit into the conduits emerging obliquely in the other direction.

8. Transporter of wafers stacked in a cassette according to any one of the preceding claims, characterised in that the tracks (6) comprise, on their lower face, a device (31) for reading a code (30) affixed to the upper face of the wafer (1) travelling on the adjacent track below.

9. Transporter of wafers stacked in a cassette according to any one of claims 1 to 7, characterised in that the tracks (6) comprise, on their upper face, a device (31) for reading a code (30) affixed to the lower face of the wafer travelling on the same track.

# FIG. 1

FIG. 2

FIG. 3

FIG. 4

FIG. 5

FIG. 6

FIG. 7

FIG. 8

# FIG 9